# EUROPEAN PATENT APPLICATION

(11) **EP 4 528 804 A1**
(43) Date of publication of application: **26.03.2025**
(21) Application number: 23198859.3
(22) Date of filing: 21.09.2023
(51) Int. Cl.: H01L 23/48, H01L 23/495, H01L 23/50

(54) **INTEGRATED CIRCUIT PACKAGE AND METHOD OF MANUFACTURING THEREOF**

(71) Applicant: Nexperia B.V., 6534 AB Nijmegen (NL)
(72) Inventor: Yandoc, Ricardo, Manchester, SK7 5BJ (GB); Milo, Dolores, Manchester (GB); Qu, Yong, Manchester, SK7 5BJ (GB)
(74) Representative: Pjanovic, Ilija

(57) **Abstract**

An integrated circuit package comprising: a die comprising circuitry comprising one or more bond pads on a first surface of the die; a conductive supporting structure allowing connection to the die, the conductive supporting structure comprising a slot; and a passive component inserted into the slot of the conductive support structure, wherein a first terminal of the passive component is electrically connected to the conductive supporting structure and the circuitry of the die.

## Description

### Technical Field

The present disclosure relates to a method of manufacturing an integrated circuit package and in particular to a method of manufacturing an integrated circuit package in which a passive component is integrated.

### Background

An integrated circuit package comprises one or more semiconducting die (which may also be referred to as chips) along with connections between the die and the substrate towards a printed circuit board (PCB). There are different techniques that are known by which a die may be packaged and mounted on the PCB.

A first type of package is referred to a clip bonded package, and comprises a plurality of leads, provided as clips, arranged along a side of a die paddle on which one or more die are mounted. One end of each of the clips contacts the PCB to form connections with other components on the PCB. The other end of each clip may connect to a connection pad on the die, either directly or via a wire between the clip and the connection pad.

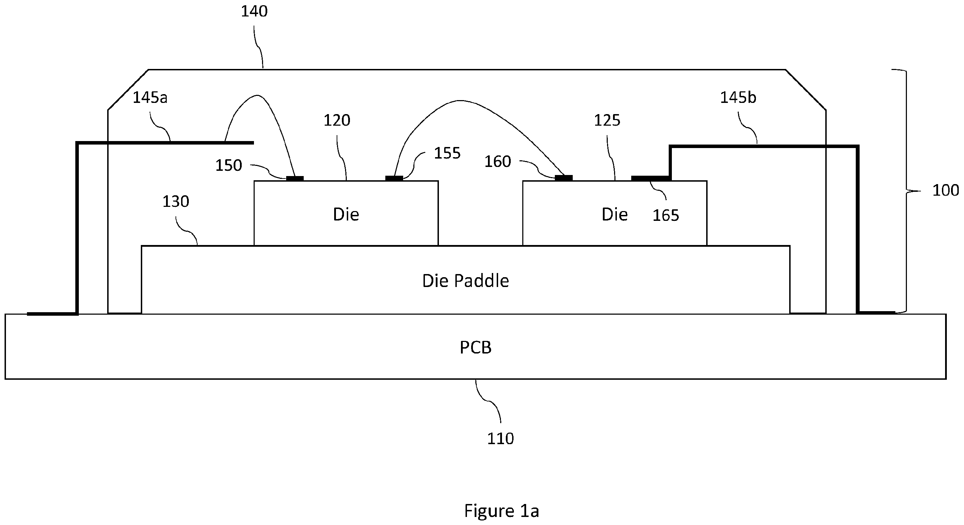

Reference is made to Figure 1a, which illustrates a clip bonded package 100, which is mounted on a PCB 110. The example package 100 comprises a first die 120 and a second die 125. The first die 120 and second die 125 are each mounted on a die paddle 130. The die paddle 130 may also be referred to as a die attach paddle and comprise a heat conductive metal, enabling heat dissipation from the die 120, 125. The die paddle 130 may comprise a plurality of sheets that are connected together. The package 100 includes an encapsulation 140 in which the die 120, 125 and die paddle 130 are provided.

To form connections between the die 120, 125 and the PCB 110, the package 100 includes a number of internal clip leads, e.g. leads 145a, 145b, extended towards an external lead. The clip leads may otherwise be referred to as leads or as interconnects. Each of the leads comprises one or more clips, which are made of a conductive material, e.g. copper. Each of these attaches at one end to the PCB 110, so to form connections with other components that are mounted onto the PCB 110. Connection pads are formed on the top surface of each of the die 120, 125 for providing connections between each die 120, 125 and the PCB and for providing connections between the die 120, 125. For example, a wire connected to bonding pads 155, 160 provides a connection between the die 120, 125. To connect die 120 to the PCB 110, a wire connects the bonding pad 150 to the clip lead 145a. To connect die 125 to the PCB 110, the die 125 is provided with bonding pad 165, which is bonded to the clip lead 145b. A mold resin 140 is also part of the die package 100, and encapsulates the components.

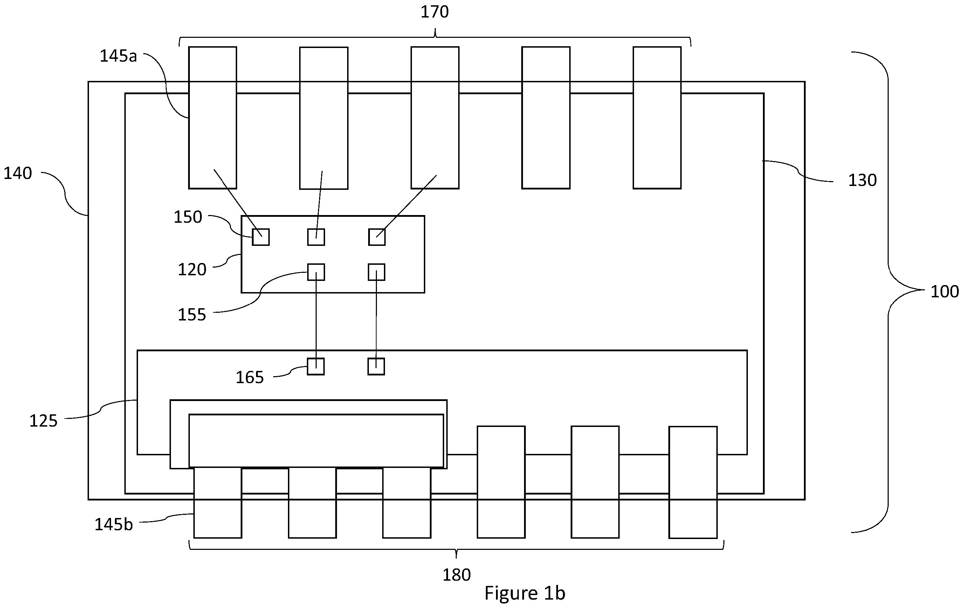

Reference is made to Figure 1b, which illustrates a further perspective of the example clip bonded package 100. As shown in Figure 1b, the package 100 includes a first set of clips 170 is arranged along a first side of the package 100, and a second set of clips 180 is arranged along a second side of the package 100. The first set of clips 170 comprises the clip lead 145a, and the second set of clips 180 includes the clip 145b. As shown, the clip 145b is connected together with further clips belonging to the second set of clips 180. Together these connected clips form a lead that is connected to the second die 125 at a bonding pad 165.

Each of the die 120, 125 comprises circuitry that may implement various functions. For example, the die 125 may comprise a field effect transistor (FET), whilst the die 120 may comprise a gate driver for the FET. Various such circuits may require a passive components for which it is impractical to implement as part of the die 120, 125, due to the size of the component. For example, a driver circuit may require a capacitor having a capacitance of, e.g. 100 nF, which may be impractical to implement as part of the driver circuit that is implemented as part of the die 120.

A second technique for mounting a die to a PCB is referred to as wirebond, in which wires from wirebond pads on the die connect to the PCB at predetermined connection points on the PCB. These wirebond pads are fixed to the active side of the die, which is positioned away from the substrate.

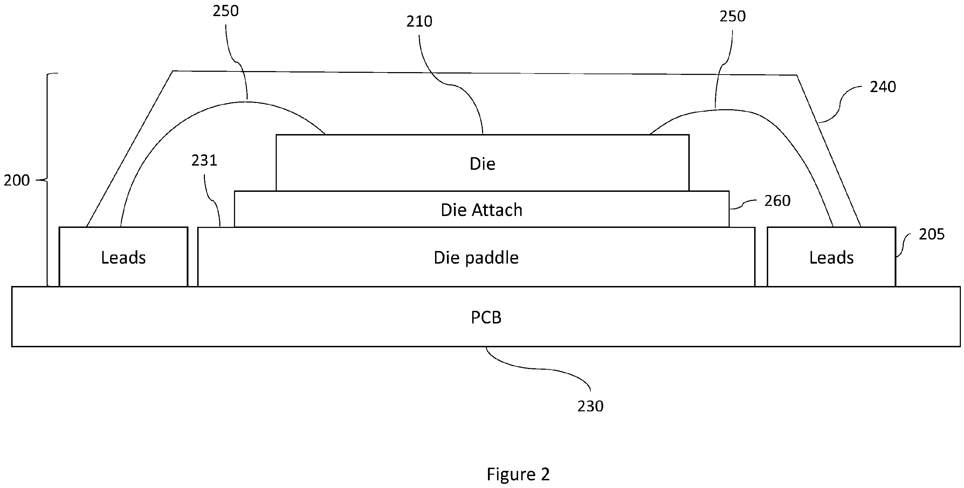

Reference is made to Figure 2, which illustrates an example of a wirebond package 200 comprising a die 210. The die 210 shown may be functionally the same as either of the die 120, 125. Connection pads on top of the die 210 are connected via wires 250 to the leads 205, so as to form appropriate connections to the PCB 230. The die 210 is fixed to the die paddle 231 using a die attach adhesive 260. A mold resin 240 surrounds and encases the die 210 and wires 250.

### Summary

There is, therefore, a requirement to implement an additional passive component along with the circuitry that is part of the die of the die package. One proposal for doing so, is to provide the passive component as a discrete component on the PCB and to connect the passive component by the PCB track. However, implementing the component on the PCB consumes additional space on the PCB. Furthermore, the package parasitic inductance and the charging loop may be large when the component is implemented on the PCB, which may undesirably compromise product performance for certain applications.

According to a first aspect, there is provided an integrated circuit package comprising: a die comprising circuitry and one or more bond pads on a first surface of the die; a conductive supporting structure allowing connection to the die, the conductive supporting structure comprising a slot; and a passive component inserted into the slot of the conductive supporting structure, wherein a first terminal of the passive component is electrically connected to the conductive supporting structure and the circuitry of the die.

The integrated circuit package is provided with a conductive supporting structure in addition to the die. A passive component is provided in a slot of the conductive supporting structure and electrically connected to the conductive supporting structure. The passive component is electrically connected via the conductive supporting structure to one of the bond pads of the die, and thus connects to the circuitry of the die. The circuitry of the die thus forms a circuit with the passive component, which is integrated as part of the integrated circuit package, without being integrated in the die itself.

According to a first example embodiment, the slot is a hole in the supporting structure, and a second terminal of the passive component may be attached to a die paddle of the package. According to a second example embodiment, the slot comprises downsets formed in two adjacent parts of the supporting structure, and a passive component is inserted in between the two supporting structures. In this case, the first terminal of the passive component is electrically connected to one of the parts of the supporting structure and to the circuitry of the die via that one of parts of the supporting structure. The two adjacent parts of the supporting structure may be two clip leads.

In some embodiments, the passive component comprises a capacitor.

In some embodiments, the integrated circuit package comprises a die paddle on which the die is mounted.

In some embodiments, a second terminal of the passive component is attached to the die paddle.

In some embodiments, at least part of the conductive supporting structure is attached to the die paddle.

In some embodiments, the integrated circuit package is a clip bonded package comprising a plurality of clip leads, wherein the conductive supporting structure comprises at least a first of the plurality of clip leads.

In some embodiments, the slot comprises a hole passing through a surface of the first of the plurality of clip leads.

In some embodiments, the first of the clip leads comprise a first surface and a second surface, wherein the first surface is positioned further from the die paddle than the second surface, wherein the hole is formed in the second surface.

In some embodiments, a first of the clip leads comprises a first downset and a second of the clip leads comprises a second downset adjacent the first downset, wherein the passive component is inserted into the first downset and the second downset, a first terminal of the passive component being electrically connected to the first of the clip leads and a second terminal of the passive component being electrically connected to the second of the clip leads, wherein a first of the bonding pads is electrically connected to the first of the clip leads so as to provide a connection between the first terminal of the passive component and the circuitry of the die.

In some embodiments, the at least part of the conductive supporting structure comprises the second of the clip leads, wherein the second of the clip leads is electrically connected to the die paddle.

According to a second aspect, there is provided a method of manufacturing an integrated circuit package, the method comprising: providing a die comprising circuitry and one or more bond pads on a first surface of the die; providing a conductive supporting structure allowing connection to the die, the conductive supporting structure comprising a slot; inserting a passive component into the slot of the conductive supporting structure; forming an electrical connection between a first terminal of the passive component and the conductive supporting structure; and connecting one of the bond pads of the die to the conductive supporting structure so as to form an electrical connection between the circuity and the first terminal of the passive component.

In some embodiments, the method comprises: providing a die paddle; and attaching the die and the conductive supporting structure to the die paddle.

In some embodiments, the method comprises attaching the second terminal of the passive component to the die paddle.

In some embodiments, the integrated circuit package is a clip bonded package, wherein the method comprises: providing a plurality of clip leads; and connecting at least some of the plurality of clip leads to at least one of the bond pads of the die, wherein the conductive supporting structure comprises a first of the plurality of clip leads.

### Brief Description of the Drawings

Some embodiments of the disclosure will now be described, by way of example only and with reference to the accompanying drawings, in which:
Figure 1a illustrates a clip bonded integrated circuit (IC) package from a first view;
Figure 1b illustrates a clip bonded IC package from a second view;
Figure 2 illustrates a wire bonded IC package;
Figure 3a provides a top view of an IC package according to a first example embodiment;
Figure 3b provides a further top view of the clip bonded IC package, including the wire connections, according to the first example embodiment;
Figure 3c illustrates a three dimensional view of the clip bonded IC package according to the first example embodiment;
Figure 3d illustrates a cross-sectional view of the clip bonded IC package according to the first example embodiment;
Figure 3e illustrates a three dimensional view part of the clip bonded IC package according to the first example embodiment;
Figure 3f illustrates a further three dimensional zoom in view with the passive component of part of the clip bonded IC package according to the first example embodiment;
Figure 4 illustrates steps in a method of manufacturing the clip bonded IC package according to the first example embodiment;
Figure 5a is a top view of the IC package according to the second example embodiment;
Figure 5b is a top view of the IC package, including the wire connections, according to the second example embodiment;
Figure 5c is a three dimensional view of the IC package according to the second example embodiment;
Figure 5d is a cross-section of the IC package according to the second example embodiment;
Figure 5e is a three dimensional view of part of the IC package according to the second example embodiment;
Figure 5f is a three dimensional view of part of the IC package with the passive component attached, according to the second example embodiment;
Figure 6 illustrates steps in a method of manufacturing the IC package according to the second example embodiment;
Figure 7 illustrates an example of circuitry that may be implemented in the IC package;
Figure 8 illustrates an example of an IC package according to the third example embodiment; and
Figure 9 illustrates a method of manufacturing the IC package.

### Detailed Description

Embodiments will be described in more detail with reference to the accompanying Figures.

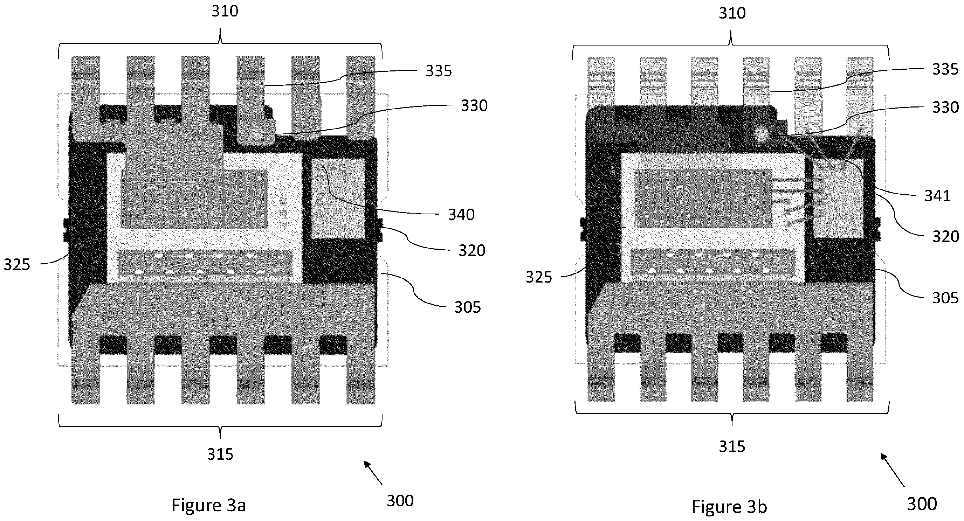

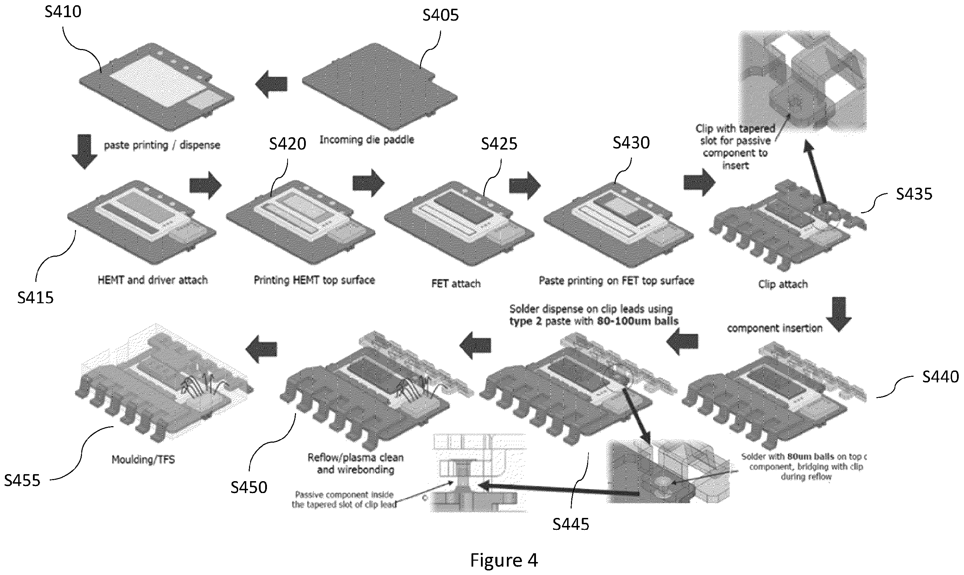

A first example embodiment of the integrated circuit package is described with respect to Figures 3a-f and Figure 4. According to the first example embodiment, the slot is formed as a hole passing through a surface of a clip lead belong to the integrated circuit device.

Reference is made to Figure 3a, which illustrates a first view of the integrated circuit package 300 according to the integrated circuit device. The integrated circuit package 300 comprises a die paddle 305 on which die 320, 325 are formed. The integrated circuit package 300 further comprises a number of clip leads, which provide connections between the die 320, 325 and further components external to the package 300. The package is, therefore, a clip bonded package. The package 300 comprises a first set of clips 310 arranged along a first side of the package and a second set of clips 315 arranged along a second edge of the package 300. As shown, the first set of clips 310 comprises multiple separate clip leads that are not electrically connected to one another. On the other hand, the second set of clips 315 are connected to form a single lead. A first clip lead 335 constitutes a conductive supporting structure having a slot 330 into which the passive component is inserted. In this embodiment, the slot is a hole passing through a surface of the clip lead 335. Each of the clips 310, 315 is made of copper or another conductive material.

Figure 3a illustrates the package 300 prior to the attachment of wires into the package to connect the die 320 to ones of the clip leads 310, and to connect the die 320 to die 325. The die 325 may comprise large connection pads to which ones of the clip leads may be directly attached. However, the die 320 comprises smaller connection pads, e.g. connection pad 340, that are connected to the clip leads or to connection pads of the die 325 via wires.

Reference is made to Figure 3b, which illustrates a further view of the integrated circuit package 300 in which the wires are shown connecting die 320 to die 325 and die 320 to ones of the clip leads 310. One of the wires 341 connects one of the connection pads of the die 320 to the clip lead 335, and thus forms a connection between a first terminal (which is bonded to the clip lead 335) of the passive component and the connection pad 340 of the die 320. The first terminal of the passive component is, thus connected to circuitry that is formed in the die 320. In this way, the passive component forms part of a circuit with the circuitry belonging to the die 320.

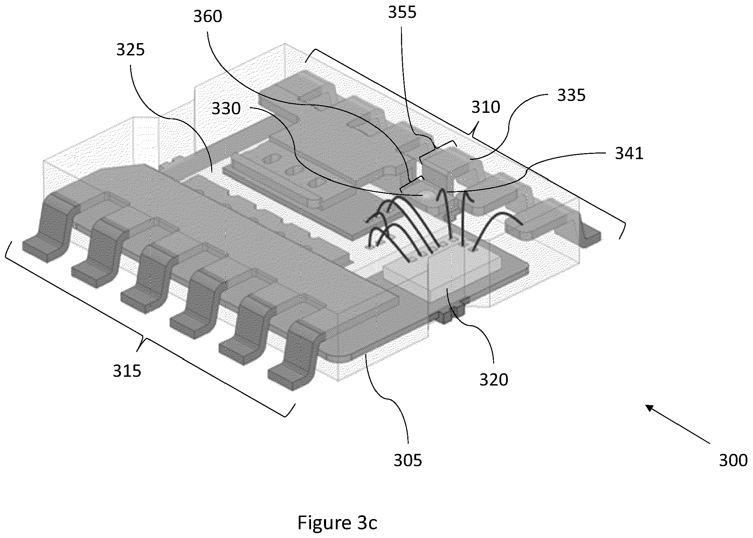

Reference is made to Figure 3c, which illustrates a further view of the integrated circuit package 300. A first terminal of the passive component is shown located at the slot 330 of the clip lead 335. The first terminal is connected to the clip lead 335, which is bonded by wire 341, thus forming an electrical connection between the first terminal of the passive component and the circuitry in the die 320. As shown in Figure 3c, the clip lead 335 comprises a raised portion 355, and a lower portion 360. The raised portion 355 is parallel to a top surface of the remaining clips. The lower portion 360 is located closer to the die paddle 305 than the raised portion 355, thus enabling the second terminal of the passive component to contact the die paddle 305 whilst minimising the required length of the passive component.

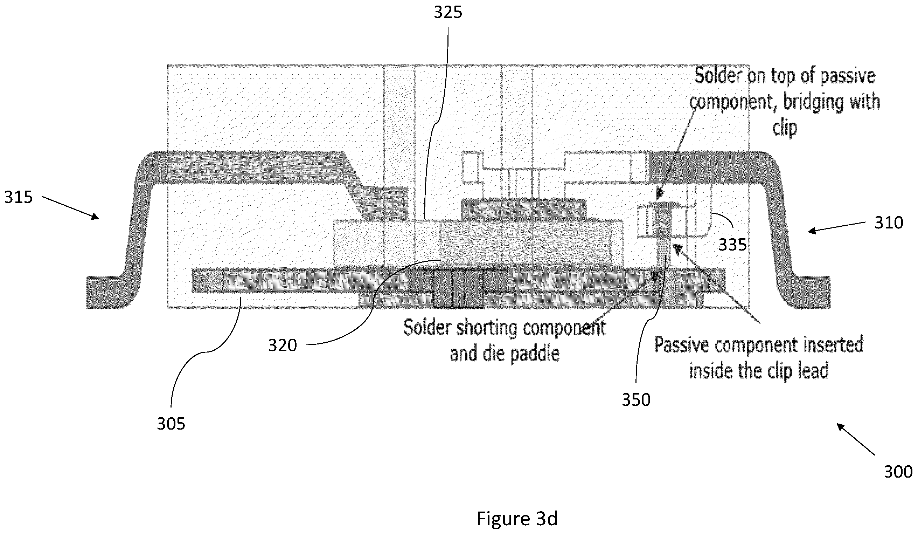

Reference is made to Figure 3d, which illustrates a further view of the integrated circuit package 300. Shown in this Figure is the passive component 350 located in the slot of the clip 335. As shown, the slot takes the form of a hole through a surface of the clip 335. The hole is orientated to be parallel to the surface of the die paddle 305. In other words, the hole is orientated such that the passive component 350 is vertical when placed in the hole. The passive component 350 is soldered at a first end to the clip 335, such that the first terminal of the passive component is electrically connected to the clip 335. The solder is formed along an edge of the top of the hole. A second terminal, which is opposite the first terminal, of the passive component may be soldered to the die paddle 305. In this case, the die paddle 305 provides a ground connection to the passive component 350.

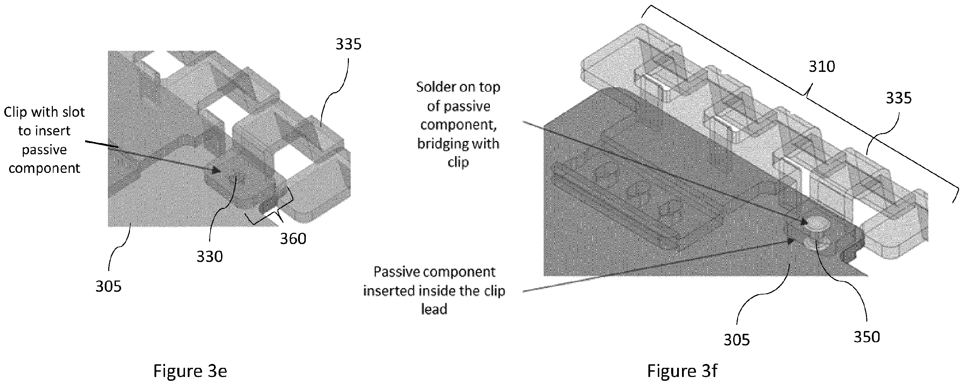

Reference is made to Figures 3e and 3f, which illustrate further parts of the integrated circuit package 300. Figure 3e shows clip 335 and the slot 330 formed in the clip 335, prior to the insertion of the passive component 350 into the slot 330. The slot 330 has a constant bore with a lip on the top surface of the portion 360 of the lead 335. The slot 330 and the passive component 350 into the slot 330 both have a substantially cylindrical shape. Figure 3f shows part of the package 300 after the passive component 350 is inserted into the slot 330. Solder is formed on top of the passive component 350 (i.e. on the first terminal), and is used to bridge the component 350 with the clip 335. Part of the passive component 350 is within the slot 330, with a further part of the passive component 350 (including the second terminal) being located beneath the slot 330.

Reference is made to Figure 4, which illustrates a series of steps that are part of a method of manufacturing the integrated circuit package 300. The method comprises (at S405) providing the die paddle 305. The die paddle 305 may comprises a plurality of sheets (e.g. 20 or more) of a conductive material connected together in parallel. Conductive material is placed (at S410) at predefined locations on the die paddle 305, e.g. by printing. The conductive material may comprise solder or another type of material. At S415, the die 320 and the die 325 are attached to the die paddle 305 on the conductive material added at S410. The die 325-may be referred to as the high electron mobility transistor (HEMT) die, whereas the die 320 may be referred to as the driver 320. The HEMT die 325 added at S415 may contain the GaN FET of a cascode FET.

At S420, conductive material is placed at predefined locations on the top surface of the die 325, e.g. by printing. At S425, field effect transistor is attached to the die 325 to complete the circuitry of die 325. The field effect transistor is attached on the conductive material added at S420. The field effect transistor may be a metal oxide semiconductor field effect transistor (MOSFET).

At S430, conductive material is placed on the surface of the FET. This surface forms the drain terminal of the cascode FET.

At S435, the clips are attached to the package 300. Some of the clips belonging to the first set of clips attach to the top surface of the FET. Others of the clips belonging to the second set of clips 315 attach to other printed surfaces of the die 325.

At S440, the component 350 is inserted into a slot 330 in the clip 335. The passive component 350 is then aligned with the surface of the copper clip 335, and the second terminal of the passive component is connected to the die paddle 305. At S445, solder is added to the clip 335 to attach the first terminal of the component 350 to the clip 335.

At S450, the wirebonding between the connection pads on the die 320, 325 and between the die 320 and ones of the clips is added. This step includes forming a connection between one of the connection pads 340 on die 320 and the clip 335. Reflow is performed as part of S450.

At S455, moulding is performed to provide the components of the die package 300 within a resin mold.

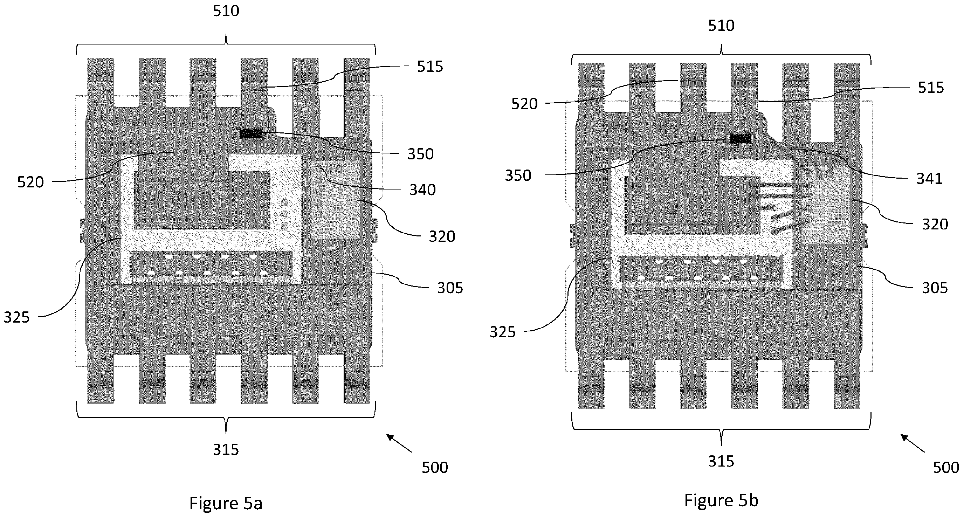

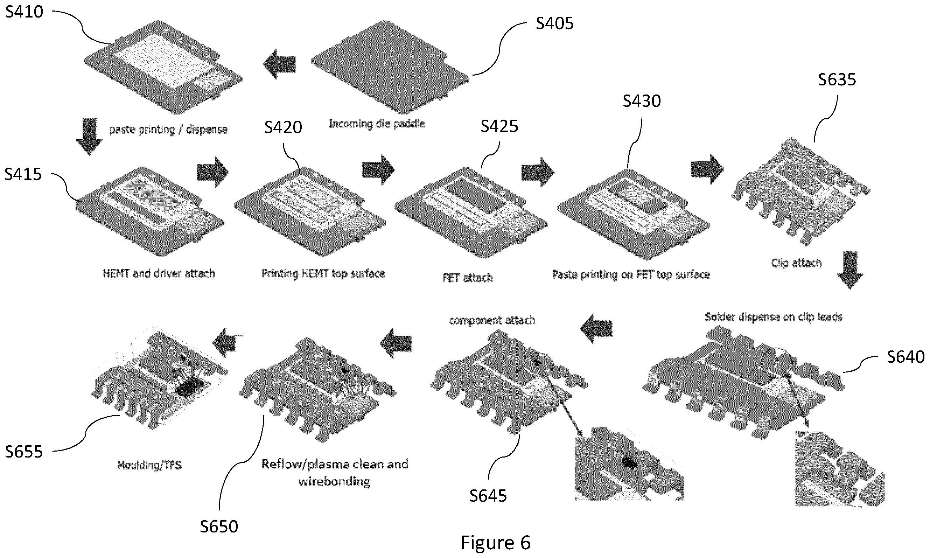

A second example embodiment of the integrated circuit package is described with respect to Figures 5a-f and Figure 6. According to the second example embodiment, a downset or half cut is made in each of two adjacent clip leads to form a slot. The passive component is then inserted into the half cut in each of the clip leads to connect the two clip leads. A connection between a die of the package and a first of the two adjacent clip leads is made in order to connect a first terminal of the passive component to the circuitry of the die. The second of the two adjacent clip leads may be connected to the die paddle so as form a connection with the ground for the second terminal of the passive component. In the description of the integrated circuit package according to the second example embodiment, elements that may be the same as in the first example embodiment are referred to with the same reference numerals.

Reference is made to Figure 5a, which illustrates the integrated circuit package 500 according to the second example embodiment. The package comprises clips 510, in addition to the clips 315. Each of the clips 315, 510 is made of copper. The passive component 350 is shown connecting the clip lead 515 to the clip lead 520. The passive component 350 is inserted into a downset (also referred to as a half-cut) in each of the two clip leads 515, 520. A first terminal of the component 350 is soldered to the clip lead 515 to form an electrical connection with the clip lead 515. A second terminal of the component 350 is soldered to the clip lead 520 to form an electrical connection with the clip lead 520.

Reference is made to Figure 5b, which illustrates a further view of the integrated circuit package 500, showing the wires connecting the die 320 to the die 325 and to ones of the clips 510. As shown, the wire 341 connects a connection pad 340 on the die 320 to the clip 515 so as to form an electrical connection between this connection pad 340 and the first terminal of the passive component 350. Thus an electrical connection between the circuitry in the die 320 and the terminal of the component 350 is formed.

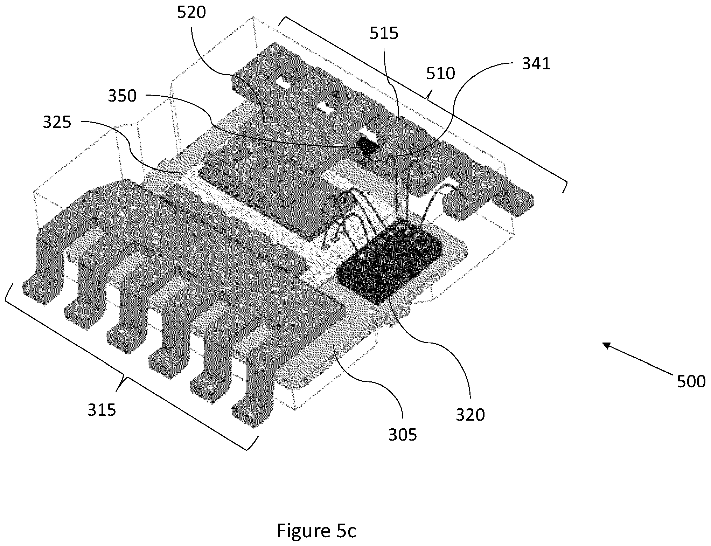

Reference is made to Figure 5c, which illustrates a further view of the integrated circuit package 500. The clip lead 520 is shown located over the die 325, but is unconnected to the circuitry of die 325 so that the second terminal of component 350 is unconnected to this circuitry.

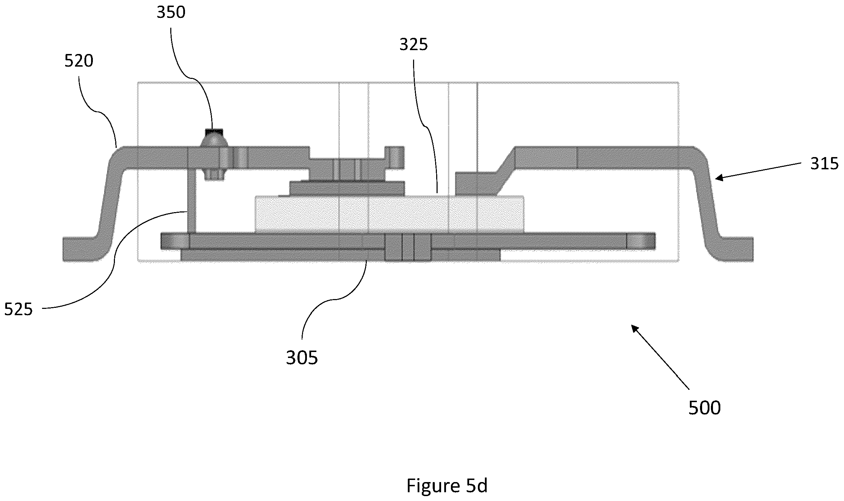

Reference is made to Figure 5d, which illustrates a further view of the integrated circuit package 500. A part 525 of the clip lead 520 is shown forming a connection with the die paddle 305. The part 525 of the clip lead 520 may be referred to as a pillar 525. Thus an electrical connection is formed between the second terminal of the passive component 350 and the die paddle 305.

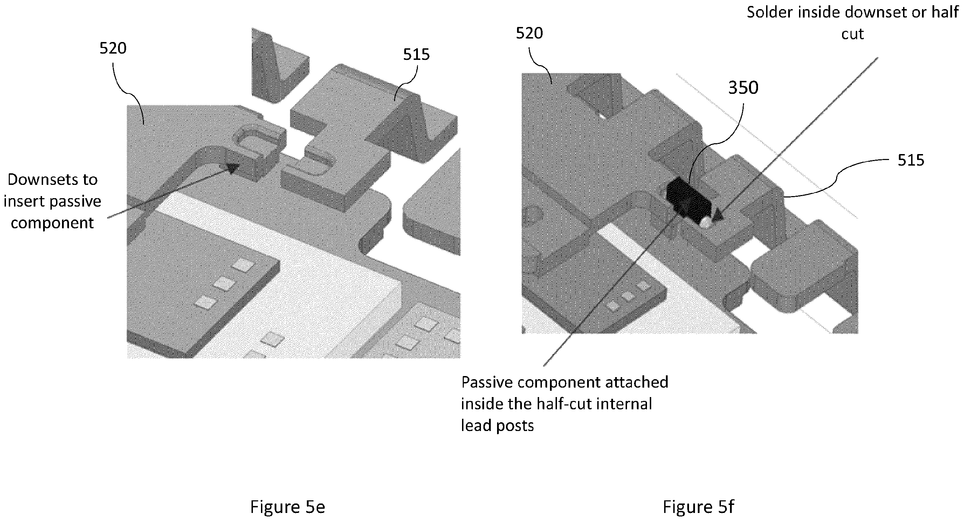

Reference is made to Figures 5e and 5f, which illustrate further views of part of the integrated circuit package 500. Figure 5e illustrates the downset made in each of the clip leads 515, 520. As is apparent from the Figure, the downset comprises a groove in the clip lead. In other words, the down set comprises a region of reduced thickness. The clip leads are provided with adjacent downsets in this way, thus providing a slot in which the passive component 350 may be inserted. As shown in Figure 5f, when the component 350 is inserted into the downset, each of the two terminals of the component 350 are soldered to one of the clips leads 515, 520 by adding solder into the downsets. The first terminal of the component 350 is soldered to the clip lead 515 and the second terminal of the component 350 is soldered to the clip lead 520.

The insertion of the passive component 350 into the downsets allows for careful control of the solder amount used to solder each of the two terminals of the passive component 350. This reduces the probability of imbalanced solder on the two terminals of the passive component 350. As a result, tombstoning during the reflow process may be prevented. Additionally, by providing the passive component 350 in the downsets, the downsets provide a housing for the passive component 350 before the curing or reflow process and so avoids the lead 515 being contaminated by solder spreading or splatter before the wirebonding process. In other words, since the solder is placed lower than the wirebond pad (i.e. in the downcut), the wirebond pad is protected from being penetrated by solder during reflow.

Reference is made to Figure 6, which illustrates a series of steps that are part of a method of manufacturing the integrated circuit package 500. The steps S405 to S430, S450 and S455 are the same as those shown in Figure 4.

The method includes the step of (at S635) attaching the clips to the package 500. The clips differ in this instance in that a half-cut, rather than a hole, is made in the clips for insertion of the passive component 350. At S640, solder is added to the half-cuts. At S645, the component 350 is placed in the half-cuts, such that it is laterally attached between the two clip leads 515, 520. The second terminal of the passive component 350 is then connected to the die paddle 305 via the clip lead 520.

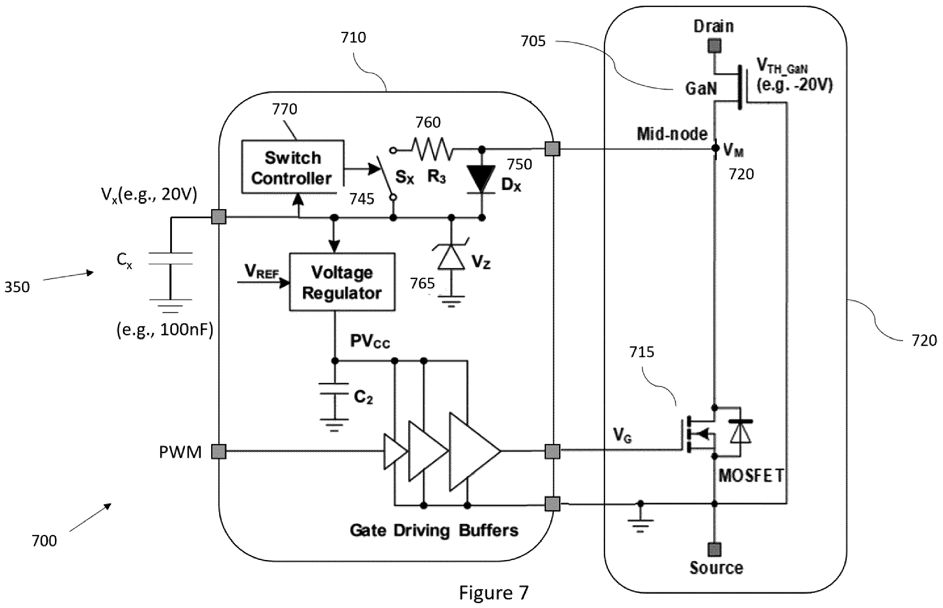

The passive component 350 may comprise different types of electrical component, e.g. a resistor, capacitor, inductor. An example will be described with respect to Figure 7, in which the passive component 350 is a capacitor that is connected to a gate driver circuit implemented in the die 320. The gate driver may be used for driving a cascode FET implemented in the die 325. The die 325 may be a high electron mobility transistor (HEMT) die 325. Together, the gate driver and the cascode FET may be referred to as a cascode switching module.

Reference is made to Figure 7 shows a schematic diagram of a cascode switching module 700, according to an embodiment of the disclosure. The module includes a bidirectional switch, Sx, 745 and a unidirectional diode, Dx, 750 connected between Cx and the midpoint voltage, V_{M}. The active switch, Sx 745 is connected in parallel with the passive diode Dx 750. The capacitor C_{X} 350 can be charged and discharged by the gate driver circuit 710.

Due to the use of the switch Sx 745 and diode Dx 750, the trade-off between reducing overshoot by increasing the capacitance of Cx and reducing power losses is decoupled because the stored energy in Cx can instead be utilized to power gate driver circuits instead of MOSFET channel dissipation.

The midpoint voltage, V_{M}, is the drain voltage of the normally-off silicon MOSFET. The source terminal may be grounded by connecting the source terminal to the die paddle 305. The gate-source voltage (V_{gs}) of the normally-on GaN device is equal to the negative of the midpoint voltage, V_{M} such that V_{M} = - V_{gs}. In the device shown in Figure 7, the voltage of the midpoint (V_{M}) is nearly or substantially zero volts when the cascode switching module is on and conducting, is at a higher voltage (for example, 25 or 30 V) when the cascode switching module is off. When the cascode switching module 700 is off, the midpoint voltage, V_{M}, increases such that the gate-source voltage (V_{gs}) of the normally-on GaN device 720 is lower than the (negative) threshold V_{gs,th} required to switch off the normally-on GaN device 720.

When the cascode switching module turns off, the midpoint voltage, V_{M}, increases (e.g. the midpoint voltage, V_{M}, may increase to 25 V) such that the gate-source voltage of the normally-on GaN device 705 is low enough to turn off. The diode, D_{X}, 750, allows current to flow to the capacitor Cx 350 to charge to the midpoint voltage, V_{M}, level (minus the diode voltage drop). Hence, the diode, D_{X}, allows energy harvesting. In addition, the diode, Dx 750, and the capacitor, Cx, clamp the midpoint voltage, V_{M}, and prevent the normally-off silicon MOSFET 720 from avalanching.

Specifically, when the MOSFET 715 is turned off and V_{M} > (-V_{gs,th}), the voltage of the midpoint, V_{M}, starts to increase until it goes beyond the predetermined voltage (-V_{gs,th}) up to a level depending on the package parasitic inductance and as dictated by the respective parasitic capacitances of the GaN and MOSFET devices 705, 715. The potential V_{M} overshoot gets significantly reduced by the capacitor, Cx, and thus limits the MOSFET 715 voltage rise and hence, the risk of MOSFET avalanche. As Cx is realized as an off-chip device, its capacitance can be much larger than an integrated capacitor (e.g., the capacitance may be 1uF for an off-chip capacitor rather than 1nF for an integrated capacitor) without the concern of efficiency compromise.

To switch the normally-on GaN device 705 off, the midpoint voltage, V_{M}, must exceed - V_{gs,th}. This means that the midpoint voltage, V_{M}, will increase to at least -V_{gs,th} (in practise, it may go a bit higher than -V_{gs,th}). The capacitor, C_{X}, may therefore charge to approximately -V_{gs,th}, although it may be a bit lower due to the voltage drop of the diode, D_{X}, 750 (which may be about 0.7 V). The charged energy of the capacitor, Cx, can be recycled to power the gate driver 710 operation instead of generating losses on the MOSFET 715 turn-on channel. By this mechanism, a gate driver power source V_{X} is internally generated, and the trade-off between reducing overshoot by increasing the capacitance of Cx 350 and increasing power losses is decoupled.

The cascode switching module can be used for some resonant converter applications (e.g., an LLC converter). To avoid undesired turn-on of the GaN device 705 when its drain voltage is oscillating, a bidirectional switch Sx 745 and a resistor R₃ 760 are used in the gate driver 710. The resistor 760 is connected between the voltage midpoint V_{M} 120 and the switch Sx 745. When the switching node V_{M} (i.e., the drain of the GaN device 705) is purposefully oscillating and its voltage is lower than the gate driver power source Vx, the switch Sx 745 is turned on to provide a curtain voltage for the middle point V_{M} 720 and thus the GaN device 705 is in an off-state. The resistor R₃ 760 limits the discharging current from the capacitor Cx 350 to the voltage midpoint V_{M} 720 and subsequently, the switch controller 745 turns off the switch Sx 745. The switch Sx 745 limits the midpoint voltage, V_{M}, drop when the cascode switching module 700 is used in a resonant application as the drain voltage can oscillate, thus preventing the switching cascode module 700 from turning on while undesired.

Alternatively, the switch Sx 745 is systematically turned on just after the turn-off of the cascode devices to maintain a minimum midpoint voltage V_{M} 720 and thus prevent unexpected turn-on of the GaN device 705 due to switching node oscillations. The current capability of switch Sx 745 is limited by the series resistor R₃ 760 (or by the on-state resistance of the switch Sx 745) to avoid a rapid discharging of the gate drive power Vx. If the switch Sx 745 current exceeds a preset level and/or if the gate driver power source voltage Vx or the midpoint voltage V_{M} 720 drops below a preset level (e.g. 7V for V_{X}, or 5V for V_{M}), the switch Sx 745 is immediately turned off to stop the action of opposing midpoint voltage V_{M} drop which leads to the undesired turn-on of the cascode module 700.

A large negative current may flow within the cascode switching module when the current transitions from one cascode switching module to another or in bidirectional converters. In such case, this current will drop the midpoint voltage V_{M}. The switch Sx 745 current is limited so that the unavailable midpoint voltage V_{M} drop in such situations does not lead to the discharge of the capacitor Cx 350. The switch Sx 745 will be turned off before turn on of the normally-off silicon MOSFET 715.

As the gate driver power source Vx is an internal power rail, when used in a larger module, it features innate galvanic isolation between the low-voltage microcontroller and the high-voltage power stage of an application because the PWM signal of the cascode switching module is the only connection between a microcontroller, MCU, and the cascode switching module. This greatly improves safety levels (including human body touch) and simplifies hardware implementation. As no external power source is needed and the parasitic capacitance between different grounds is substantially reduced, the gate driver CMTI performance is significantly improved.

A Zener diode Vz 765 is connected in parallel to the capacitor Cx 350. The Zener diode 765 may be formed within the same package as the normally-on GaN device 705 and the normally-off MOSFET 715, or may be an external component placed in parallel to the capacitor Cx 350. If the consumption of the gate driver 715 is insufficient to absorb the leakage current from the GaN device 705, then integrated Zener diode Vz 765 limits the voltage on the capacitor Cx 350 (i.e., the gate driver power source voltage Vx). This is also beneficial to clamp the midpoint voltage V_{M} 720 spikes.

In the example module of Figure 7, there is a voltage regulator in the gate driver 710. This generates a dedicated supply voltage for the gate driving buffers, although other embodiments may not include a voltage regulator.

Since the CX 350 is discrete and is quickly charged in nano-second range during the turn-off mode of the MOSFET 715, package parasitic inductance and quick charging loop should be minimized. By implementing the discrete capacitor CX 350 as part of the package 300, 500, the package parasitic inductance and charging loop may be minimised, so as to avoid comprising the product performance.

In some embodiments, the passive component 350 may be provided in a different type of conductive supporting structure of the package other than a clip lead.

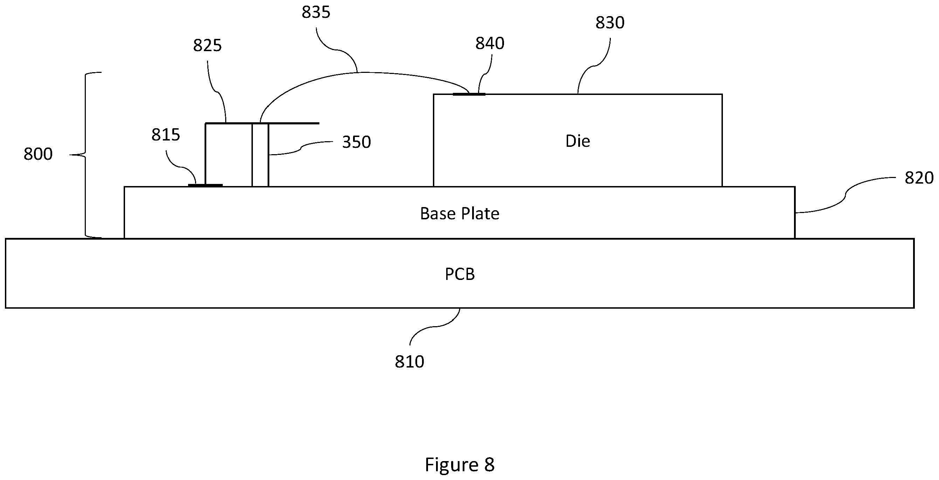

Reference is made to Figure 8, which illustrates an integrated circuit package 800 according to a third example embodiment. As shown, the integrated circuit package 800 includes a base plate 820 to which the die 830 is bonded. The die 830 may be connected to predetermined connection points on the PCB 810 by wires connecting connection pads on the die 830 directly to the PCB 810 (e.g. as illustrated in Figure 2) or by clip leads that are bonded to the PCB 810 and to connections pads on the die 830 (e.g. as illustrated in Figures 1a and 1b).

The package 800 comprises a supporting structure 825 that is connected to a base plate 820. The supporting structure 825 may be connected to an insulating pad 815 on the base plate 820. The passive component 350 is inserted into a slot formed in a surface of the supporting structure 825. The passive component 350 is soldered on a first terminal so as to form an electrical connection between the first terminal and the supporting structure 825. The supporting structure 825 is connected by a wire 835 to the connection pad 840 on the surface of the die 830 so as to form an electrical connection between circuitry of the die 830 and the first terminal of the passive component 350.

In each of the above described integrated circuit packages 300, 500, 800, a conductive supporting structure is provided in which the passive component 350 is provided. In the first and second example embodiments, this structure takes the form of a clip lead 335, 515, whilst in the third example embodiment, this structure takes the form of a separate structure 810 independent of the leads. In each case, the passive component is part of an encapsulated or molded semiconductor package 300, 500, 800.

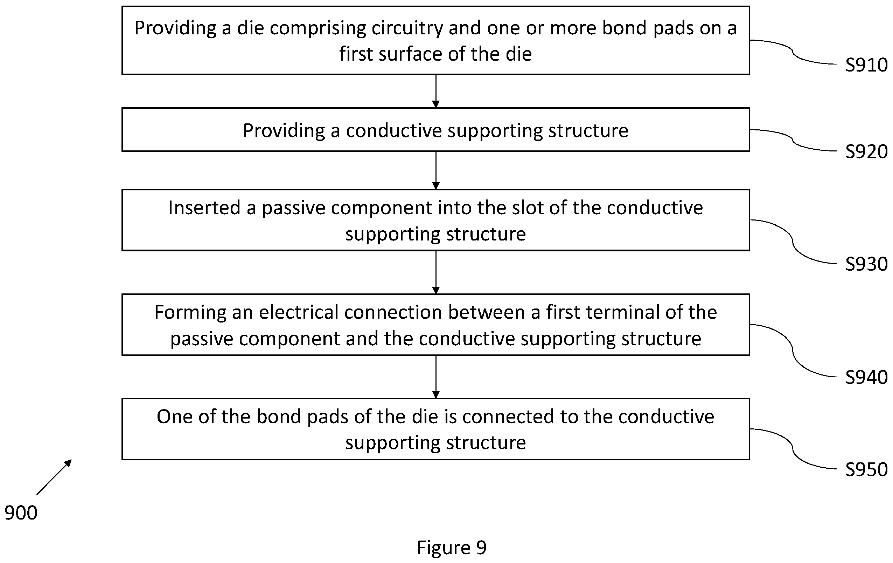

Reference is made to Figure 9, which illustrates a method 900 according to example embodiments.

At S910, a die, e.g. die 325 or die 830, is provided. The die comprises circuitry and one or more bond pads on a first surface of the die.

At S920, a conductive supporting structure is provided. The conductive supporting structure may be structure 825, clip lead 335, or clip lead 515. The conductive supporting structure is provided with a slot.

At S930, a passive component 350 is inserted into the slot of the conductive supporting structure. This step is illustrated at S445 and S645 in Figures 4 and 6

At S940, an electrical connection between a first terminal of the passive component 350 and the conductive supporting structure is formed. This step is illustrated at S450 in Figures 4 and 6.

At S950, the one of the bond pads of the die provided at S910 is connected to the conductive supporting structure.

It would be appreciated that the embodiments have been described by way of example only.

## Claims

1. An integrated circuit package comprising:
a die comprising circuitry and one or more bond pads on a first surface of the die;
a conductive supporting structure allowing connection to the die, the conductive supporting structure comprising a slot; and
a passive component inserted into the slot of the conductive supporting structure, wherein a first terminal of the passive component is electrically connected to the conductive supporting structure and the circuitry of the die.

2. An integrated circuit package as claimed in claim 1, wherein the passive component comprises a capacitor.

3. An integrated circuit package as claimed in claim 1 or claim 2, wherein the integrated circuit package comprises a die paddle on which the die is mounted.

4. An integrated circuit package as claimed in claim 3, wherein a second terminal of the passive component is attached to the die paddle.

5. An integrated circuit package as claimed in claim 3 or claim 4, wherein at least part of the conductive supporting structure is attached to the die paddle.

6. An integrated circuit package as claimed in any preceding claim, wherein the integrated circuit package is a clip bonded package comprising a plurality of clip leads, wherein the conductive supporting structure comprises at least a first of the plurality of clip leads.

7. An integrated circuit package as claimed in claim 6, wherein the slot comprises a hole passing through a surface of the first of the plurality of clip leads.

8. An integrated circuit package as claimed in claim 7 when dependent upon claim 3, wherein the first of the clip leads comprise a first surface and a second surface, wherein the first surface is positioned further from the die paddle than the second surface, wherein the hole is formed in the second surface.

9. An integrated circuit package as claimed in any of claims 6 to 8, wherein a first of the clip leads comprises a first downset and a second of the clip leads comprises a second downset adjacent the first downset, wherein the passive component is inserted into the first downset and the second downset, a first terminal of the passive component being electrically connected to the first of the clip leads and a second terminal of the passive component being electrically connected to the second of the clip leads,
wherein a first of the bonding pads is electrically connected to the first of the clip leads so as to provide a connection between the first terminal of the passive component and the circuitry of the die.

10. An integrated circuit as claimed in claim 9 when dependent upon claim 5, wherein the at least part of the conductive supporting structure comprises the second of the clip leads, wherein the second of the clip leads is electrically connected to the die paddle.

11. A method of manufacturing an integrated circuit package, the method comprising:
providing a die comprising circuitry and one or more bond pads on a first surface of the die;
providing a conductive supporting structure allowing connection to the die, the conductive supporting structure comprising a slot;
inserting a passive component into the slot of the conductive supporting structure;
forming an electrical connection between a first terminal of the passive component and the conductive supporting structure; and
connecting one of the bond pads of the die to the conductive supporting structure so as to form an electrical connection between the circuity and the first terminal of the passive component.

12. A method as claimed in claim 11, comprising:
providing a die paddle; and
attaching the die and the conductive supporting structure to the die paddle.

13. A method as claimed in claim 12, comprising attaching the second terminal of the passive component to the die paddle.

14. A method as claimed in any of claims 11 to 13, wherein the integrated circuit package is a clip bonded package,
wherein the method comprises:
providing a plurality of clip leads; and
connecting at least some of the plurality of clip leads to at least one of the bond pads of the die,
wherein the conductive supporting structure comprises a first of the plurality of clip leads.
